(19) Europäisches Patentamt
European Patent Office
Office européen des brevets

(11) EP 3 587 521 A1

# (12) EUROPÄISCHE PATENTANMELDUNG

(43) Veröffentlichungstag:
**01.01.2020 Patentblatt 2020/01**

(21) Anmeldenummer: **18190210.7**

(22) Anmeldetag: **22.08.2018**

(51) Int Cl.:
***C09D 165/00*** (2006.01) ***C08L 65/00*** (2006.01)
***H01L 35/24*** (2006.01) ***H01L 35/28*** (2006.01)
***C09D 5/24*** (2006.01) ***C09D 11/52*** (2014.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **21.06.2018 EP 18179061**
**21.06.2018 EP 18179067**

(71) Anmelder:
- **otego GmbH**
  **76131 Karlsruhe (DE)**
- **Karlsruher Institut für Technologie**
  **76131 Karlsruhe (DE)**

(72) Erfinder:
- **ASLAN, Silas Mehmet**
  **76137 Karlsruhe (DE)**
- **GALL, André**
  **76137 Karlsruhe (DE)**
- **LIEBER, Patrick**
  **7631 Karlsruhe (DE)**
- **LEMMER, Uli**
  **76228 Karlsruhe (DE)**
- **BRÄSE, Stefan**
  **53842 Troisdorf (DE)**

(74) Vertreter: **Hoppe, Georg Johannes**
**Darani Anwaltskanzlei**
**Beuckestrasse 20**
**14163 Berlin (DE)**

## (54) SIEBDRUCKTINTE UND VERFAHREN ZU DEREN HERSTELLUNG

(57) Die Erfindung betrifft ein Verfahren zur Herstellung von Poly(3,4-ethylendioxythiophen) (PEDOT) Siebdrucktinte.

Das Verfahren umfasst die folgenden Schritte:
a) Bereitstellung von
- 3,4-Ethylendioxythiophen Monomeren,
- Micellen aus Natrium-Dodecylsufat (SDS) und
- Eisen(III)-Chlorid; und

b) Reaktion der unter a) genannten Edukte zu PEDOT-Nanostrukturen
wobei die erhaltenen PEDOT-Nanostrukturen mit mindestens einem Lösungsmittel und/oder einem Lösungsmittelgemisch aufweisend einen aliphatischen Alkohol, insbesondere Ethanol gewaschen werden.

EP 3 587 521 A1

**Beschreibung**

Die Erfindung betrifft das Gebiet der thermoelektrischen Materialien. Im Speziellen betrifft die Erfindung eine Siebdrucktinte und ein Verfahren zur Herstellung derselben, wobei die Siebdrucktinte thermoelektrische Eigenschaften aufweist. Sie ist geeignet für den rotativen und den sheet-to-sheet Siebdruck auf Polymer- und Glassubstraten.

**Beschreibung**

Thermoelektrische Materialien haben die Eigenschaft, aus Temperaturunterschieden Strom zu erzeugen. Sie können auf vielfältige Weise zur Anwendung kommen, z. B. für den Einsatz als unabhängige Energiequelle für drahtlose Sensoren und Aktoren.

Zur Herstellung eines thermoelektrischen Generators werden Blöcke von thermoelektrisch aktiven Materialien zwischen zwei feste Träger platziert, miteinander in Kontakt gebracht und einer Temperaturdifferenz ausgesetzt. Dabei liefert der thermoelektrische Generator Strom.

Um thermoelektrische Generatoren per Siebdruck herzustellen, fehlt es bisher an geeigneten Siebdrucktinten, die schnell und kostengünstig hergestellt werden können.

Die Erfindung stellt ein Verfahren bereit, um eine Siebdrucktinte mit thermoelektrischen Eigenschaften für die Herstellung von thermoelektrischen Generatoren herzustellen. Weiterhin stellt die Erfindung ein p-Typ Material bereit, das im Siebdruckverfahren abgeschieden und in einem thermoelektrischen Generator verwendet werden kann.

Ein getrockneter dünner Film der erfindungsgemäßen Siebdrucktinte, beispielsweise mit einer Schichtdicke von 0,5 bis 10 $\mu$m, besitzt thermoelektrische Eigenschaften, d. h. er kann aus Temperaturunterschieden Energie gewinnen. Dazu wird neben der erfindungsgemäßen, p-Typ Siebdrucktinte auch ein n-Typ Material benötigt, dass ebenfalls siebdruckfähig sein sollte. Als p-Typ wird ein halbleitendes Material verstanden, bei dem die Majoritätsladungsträger, also die Ladungsträgerspezies, die den größten Teil des Stroms leitet, Löcher oder Defektelektronen sind. Bei einem n-Typ Material sind die Majoritätsladungsträger Elektronen.

Als p-Material werden die hier beschriebenen erfindungsgemäßen Nanostrukturen von Poly(3,4-ethylendioxythiophen) dotiert mit Dodecylsulfat verwendet.

Unter dem Begriff "Nanostrukturen" werden hier längliche Strukturen mit einer Länge von insbesondere 2 $\mu$m bis 30 $\mu$m und einem Durchmesser von insbesondere 20 nm bis 200 nm verstanden, welche sich beispielsweise mit einem Rasterkraft- oder Rasterelektronenmikroskop erkennen lassen. Bisweilen werden derartige flexible längliche Nanostrukturen auch als "Nanodrähte" bezeichnet.

Der Begriff "Siebdruck" bezeichnet ein Druckverfahren, bei dem die Druckfarbe mit einer Rakel durch ein feinmaschiges Gewebe hindurch auf das zu bedruckende Substrat gedruckt wird. Der Begriff umfasst sowohl den sogenannten sheet-to-sheet Siebdruck, als auch den rotativen Siebdruck, wie er in Rolle-zu-Rolle Anlagen verwendet wird.

Der Begriff "kritische Micellkonzentration" bezeichnet die Konzentration eines Tensids, bei der sich Micellen bilden.

Die Erfindung betrifft in einem Aspekt ein Verfahren zur Herstellung von Poly(3,4-ethylendioxythiophen) (PEDOT) Siebdrucktinte.

Die Synthese der Siebdrucktinte wird ausgehend vom Monomer 3,4-Ethylendioxythiophen durchgeführt. Daneben werden Micellen aufweisend oder bestehend aus Natrium-Dodecylsulfat (SDS) und Eisen(III)-Chlorid als weitere Edukte bereitgestellt. Die Reaktion wird insbesondere im Bereich von 20°C bis 70°C durchgeführt. In einer Ausführungsform des Verfahrens wird die Reaktion im Temperaturbereich von 20 bis 24 °C durchgeführt. Die Reaktionsdauer kann 72 Stunden betragen (Figur 3). Das Prozessschema zur Synthese ist in Figur 4 gezeigt.

Die genannten Micellen bilden sich oberhalb der kritischen Micellkonzentration in wässrigem Medium aus Natrium-Dodecylsufat (SDS). Durch Eisen(III)-Chlorid werden diese Strukturen "fixiert" und als flockiger beiger Niederschlag gefällt. Durch Zugabe von 3,4-Ethylendioxythiophen Monomeren (EDOT) entstehen in den gefällten Micellen, durch die Anwesenheit von Eisen(III)-Chlorid, PEDOT-Nanostrukturen (Schema 1):

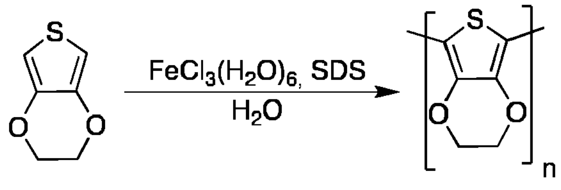


**Schema 1**: Synthese von PEDOT-Nanostrukturen

Nach der erfolgten Reaktion von 3,4-Ethylendioxythiophen Monomeren in den Micellen aus SDS und Eisen(III)-Chlorid müssen die als Produkt erhaltenen PEDOT-Nanostrukturen aufgereinigt werden. Es müssen also unerwünschte Nebenprodukte der Reaktion entfernt werden, wie beispielsweise überschüssiges SDS, Eisen(II)- sowie Eisen(III)-Salze, Dodecylsulfonsäure (HDS) und Salzsäure.

Zur Aufreinigung werden die PEDOT-Nanostrukturen als Syntheseprodukt in einer Ausführungsform des Verfahrens zunächst zentrifugiert.

Das Syntheseprodukt wird als gemäß dem Verfahren mit mindestens einem Lösungsmittel und/oder mit einem Lösungsmittelgemisch aufweisend einen aliphatischen Alkohol, insbesondere Ethanol, vermengt und somit gewaschen und optional zentrifugiert.

Anschließend kann das Syntheseprodukt bzw. das Zentrifugat mit dem mindestens einen Lösungsmittel, insbesondere mit Ethylenglykol, ohne Zusatz eines aliphatischen Alkohols gewaschen werden.

Das mindestens eine Lösungsmittel kann ausgewählt sein aus der Gruppe bestehend aus: Ethylenglykol (Ethan-1,2-diol), Diethylenglykol, Ethylenglykolmonomethylether, Ethylenglykol dimethylether, Triethylenglykol, Tetraethylenglykol, Triethylenglykol monomethylether, Triethylenglykoldimethylether (1,2-Bis(2-methoxyethoxy)ethan), Tetraethylenglykolmonomethylether und Tetraethylenglykoldimethylether. Ebenso kann eine Mischung einer beliebigen Anzahl der oben genannten Losungsmittel zum Waschen verwendet werden, insbesondere zwei oder drei der genannten Lösungsmittel.

Bevorzugt ist die Verwendung von Ethylenglykol als Lösungsmittel.

Der aliphatische Alkohol kann ausgewählt sein aus der Gruppe bestehend aus: Methanol, Ethanol, 1-Propanol, 2-Propanol, 1-Butanol, 2-Butanol, 1-Pentanol, 2-Pentanol, 1-Hexanol, 2-Hexanol, 1-Heptanol, 2-Heptanol, 1-Octanol, 2-Octanol, 1-Nonanol, 2-Nonanol, 1-Decanol und 2-Decanol.

Bevorzugt ist die Verwendung von Ethanol als aliphatischem Alkohol in dem Verfahren.

Das Reaktionsprodukt wird in weiteren Ausführungsformen nach dem ersten Waschen mit mindestens einem Lösungsmittel und/oder einem Lösungsmittelgemisch aufweisend einen aliphatischen Alkohol durch einen zusätzlichen Energieeintrag, insbesondere durch Ultraschall oder Rühren (beispielsweise eines Ultraschallfingers oder eines Ultra-Turrax Rührers) behandelt und anschließend zentrifugiert.

Dementsprechend kann das Verfahren in einer Ausführungsform neben dem Schritt des Waschens der erhaltenen PEDOT-Nanostrukturen mit mindestens einem Lösungsmittel und/oder einem Lösungsmittelgemisch aufweisend einen aliphatischen Alkohol die folgenden zusätzlichen Schritte umfassen:

- Zentrifugieren des erhaltenen Reaktionsgemisches, insbesondere vor einem weiteren Waschen und/oder
- Einbringen von Energie, z. B. mittels Ultraschallbehandlung oder Rühren.

In einigen Ausführungsformen der Erfindung wird der Schritt des Waschens mit mindestens einem Lösungsmittel und/oder einem Lösungsmittelgemisch aufweisend einen aliphatischen Alkohol mehrmals wiederholt. Zwischen den einzelnen Waschschritten kann, wie beschrieben zentrifugiert werden und/oder Energie eingetragen werden.

In einigen Ausführungsformen des Verfahrens erfolgt zunächst ein Waschen des Reaktionsproduktes mit einer Mischung aus Ethylenglykol und Wasser, gefolgt von einem zweiten Waschschritt mit reinem Ethylenglykol, gefolgt von einem dritten Waschschritt mit reinem Ethylenglykol.

In einer Ausgestaltung des Verfahrens erfolgt das Waschen mit einem Gemisch aus dem genannten Lösungsmittel und dem aliphatischen Alkohol, insbesondere Ethanol, im Verhältnis 3:1 bis 5:1.

In bevorzugter Weise wird das Waschen mit einem Ethylenglykol:Ethanol Gemisch im Verhältnis von 4:1 durchgeführt.

In einer Ausführungsform des erfindungsgemäßen Verfahrens wird das Waschen des Reaktionsproduktes nicht mit 100 % Ethanol durchgeführt.

In einem weiteren Schritt des Verfahrens können die PEDOT-Nanostrukturen nach dem Waschen mit mindestens einem Lösungsmittel und/oder einem Lösungsmittelgemisch aufweisend einen aliphatischen Alkohol mit Ethylenglykol erhitzt werden. Das sich ergebende Gemisch wird hierbei in einem Überschuss, definiert als PEDOT-Fluid zu Ethylenglykol von 1:2 bis 1:10 wobei bevorzugt bei einem Verhältnis von 1:10, von Ethylenglykol erhitzt. Der Überschuss von PEDOT-Fluid zu Ethylenglykol liegt insbesondere im Bereich von 1:2 bis 1:10, bevorzugt bei einem Verhältnis von 1:10. Das Gemisch wird auf 70 °C bis 180 °C erhitzt, bevorzugt auf 100 °C bis 130 °C, besonders bevorzugt auf 120 °C (z. B. für 30 bis 60 Minuten). Nach dem Erhitzen wird in verschiedenen Ausführungsformen unmittelbar heiß zentrifugiert (also im Wesentlichen mit der Temperatur, auf die zuvor erhitzt worden ist).

Beispielsweise werden 5 g PEDOT-Fluid mit ca. 1,7 % bis 2,3 % PEDOT-Nanostruktur Feststoffgehalt, mit 50 ml Ethylenglykol versetzt und erhitzt wird. Dadurch werden Verunreinigungen ausgewaschen und die thermoelektrischen Kennzahlen der resultierenden Beschichtungen verbessert (s. auch Figur 1).

Weiterhin kann durch mindestens ein polymeres Additiv das Verhalten des Fluids beim rotativen Siebdruck angepasst werden, das gemäß einer Ausführungsform des Verfahrens in einem Schritt hinzugegeben wird. Das Additiv

verbessert bzw. ermöglicht die gleichmäßige Verteilung im Siebdruckwerk. Dadurch wird gewährleistet, dass eine zu bedruckende Folie komplett bedruckt werden kann.

Das polymere Additiv zeichnet sich aus durch ein Viskositätsmittel $M_v$ von 100.000 bis 10.000.000 aus und sollte in kaltem oder heißem Ethylenglykol löslich sein.

In einer Ausführungsform des Verfahrens ist das polymere Additiv Polyvinylpyrrolidon oder Polyethylenoxid mit dem Viskositätsmittel $M_v$ >= 8.000.000. Bevorzugt ist Polyethylenoxid mit dem Viskositätsmittel von $M_v$ = 100.000 bis $M_v$ = 7.000.000 oder Polyethylenoxid mit dem Viskositätsmittelvon $M_v$ = 8.000.000.

Ein weiterer Aspekt der Erfindung betrifft die Verwendung von Poly(3,4-ethylendioxythiophen) Siebdrucktinte zur Herstellung eines thermoelektrischen Generators.

Ein weiterer Aspekt der Erfindung betrifft eine Siebdrucktinte, aufweisend Nanostrukturen von Poly(3,4-ethylendioxythiophen) bzw. eine Siebdrucktinte, die herstellbar ist durch ein Verfahren der hier beschriebenen Art.

Ein weiterer Aspekt der Erfindung betrifft die Verwendung von Ethylenglykol, *N*-Methylpyrrolidon, Dimethylsulfoxid, *N*-Methylformamid, 1-Methoxypropan-2-ol, 4-Hydroxy-4-Methylpentan-2-on, 1-Butanol und/oder 1-Pentanol zur Herstellung einer Tinte für den Siebdruck, insbesondere für den rotativen Siebdruck.

Ein weiterer Aspekt der Erfindung betrifft einen thermoelektrischen Generator, aufweisend mindestens eine Schicht von Poly(3,4-ethylendioxythiophen) und/oder aufweisend eine Schicht einer Siebdrucktinte der hier beschriebenen Art. Der thermoelektrische Generator weist in einer Ausführungsform auch mindestens eine Schicht aufweisend Titandisulfid auf, insbesondere wie hier beschreiben.

In einem weiteren Aspekt betrifft die Erfindung ein Siebdruckverfahren, welches den Schritt der Verwendung einer Siebdrucktinte der hier beschriebenen Art aufweist.

Durch das erfindungsgemäße Verfahren wird eine hochviskose siebdruckfähige PEDOT-Nanostruktur-Tinte bereitgestellt. Die Viskosität liegt im Bereich von $10^7$ mPas (bei Scherraten von $10^{-3}$ 1/s) bis bei $10^1$ mPas (bei Scherraten von $10^3$ 1/s). Besonders bevorzugt im Bereich von $10^6$ mPas (bei Scherraten von $10^{-3}$ 1/s) bis $10^2$ mPas (bei Scherraten von $10^2$ 1/s entsprechend einem scherverdünnendem nicht-newtonschen Fluid). Die rheologischen Untersuchungen wurden an einem Rheometer des Herstellers Anton Paar mit der Modellbezeichnung Physica MCR 101 mit einer Kegel-Platte Geometrie durchgeführt.

Bei dem erfindungsgemäßen Verfahren werden spezielle Aufreinigungsschritte verwendet. Das resultierende Fluid haftet sehr gut auf Glas und Kunststofffolien, wie z. B. auf Polyethylenterephthalat (PET) oder Polyethylennaphthalat (PEN).

Die Reaktionsabfolge von PEDOT-Nanostrukturen zur Herstellung des siebdruckfähigen PEDOT-Fluids ist in Figur 1 gezeigt.

**Beispiele**

Beispiel 1 - **Synthese einer Siebdrucktinte**

*Lösung A*

Bei Raumtemperatur und Umgebungsluft wird ein 500 ml Becherglas mit $FeCl_3$ x 6 $H_2O$ (16,7 g, 61,8 mmol) beladen und mit 200 ml destilliertem Wasser gefüllt. Die Mischung wird auf einer Magnetrührplatte bei 500 U/min gerührt, bis sich eine orangene trübe Lösung gebildet hat.

*Lösung B*

Bei Raumtemperatur und Umgebungsluft wird ein 2 Liter Kolben mit 1,8 l destilliertem Wasser gefüllt. Unter Rühren wird Natrium-Dodecylsulfat (17,4 g, 59,7 mmol) zugefügt und gerührt, bis es gelöst ist.

*Polymerisationsreaktion*

Lösung A wird nun unter Rühren von Lösung B zu Lösung B zugegeben. Dabei bildet sich ein flockiger beiger Niederschlag. Nach 20 Minuten wird zur Suspension 3,4-Ethylendioxythiophen (EDOT) (11,4 g, 8,49 ml, 80 mmol) gegeben. Die Reaktionsmischung wird bei Raumtemperatur für 70 Stunden gerührt, bis sich eine tiefblaue Reaktionsmischung gebildet hat.

*Waschprozess*

Das Rühren wird eingestellt und nach einer Stunde kann der Überstand vorsichtig abdekantiert werden. Der blaue Rückstand wird zentrifugiert und der entstehende Überstand abdekantiert. Der Rückstand wird folgendermaßen

aufgereinigt.

Erst erfolgt die Zugabe von Ethylenglykol:Ethanol (4:1, 800 ml), anschließend die Beschallung mittels Ultraschall-Sonotrode (15 Minuten kontinuierlich) danach das Zentrifugieren und Abdekantieren des Überstandes.

Diese Schrittabfolge wird zweimal wiederholt, wobei reines Ethylenglykol (800 ml) statt dem Ethylenglykol:Ethanol-Gemisch verwendet wird.

Der entstehende blaue Rückstand wird in Ethylenglykol (z.B. Verhältnis 200 g PEDOT-Fluid zu 2 l Ethylenglykol) bei 120 °C erhitzt und gerührt. Anschließend wird heiß (also ohne vorheriges Abkühlen des Gemisches) zentrifugiert und abdekantiert. Der Rückstand kann unmittelbar als Siebdrucktinte im sheet-to-sheet Siebdruck verwendet werden. Die thermoelektrischen Kennzahlen von getrockneten Beschichtungen dieses Fluids betragen 1260 S/cm und 21,8 μV/K.

Für die Ermittlung der Leitfähigkeit wurden Beschichtungen aus den PEDOT-Tinten auf Glasobjektträger aufgebracht. Anschließend wurden mit Hilfe von Silberleitlack zwei Silber-Elektroden auf die Beschichtung aufgetragen. Mit Hilfe eines Multimeters wurde der Widerstand der Schichten gemessen und der Flächenwiderstand (Ω/□) berechnet. Die Schichtdicke der Beschichtungen wurde über ein DektakXT (Bruker) Profilometer an zwei beliebigen Stellen zwischen den Elektroden gemessen und der Durchschnittswert berechnet. Die spezifische elektrische Leitfähigkeit wurde entsprechend der Formel 1 / (Flächenwiderstand · Schichtdicke) aus den erhaltenen Werten bestimmt.

Der Seebeck-Koeffizient wurde mithilfe von zwei unterschiedlich temperierbaren Peltierelementen gemessen. Die Thermospannung und die anliegende Temperaturdifferenz wurde durch Kupferelektroden direkt auf der Oberfläche des Films auf dem Glasobjektträger gemessen. Aus Messpunkten bei verschiedenen Temperaturdifferenzen wurde der Seebeck-Koeffizient berechnet.

**Beispiel** 2 - **Synthese einer Siebdrucktinte**

Weiterhin wurden PEDOT-Nanostrukturen mit einem Reaktionsvolumen von 30 Litern dargestellt.

*Lösung A*

Bei Raumtemperatur wird ein 3 Liter Becherglas mit $FeCl_3$ x 6 $H_2O$ (140 g, 9,26 mol) beladen und mit 3 l destilliertem Wasser gefüllt. Die Mischung wird auf einer Rührplatte bei 500 U/min gerührt bis sich eine orangene trübe Lösung gebildet hat.

*Lösung B*

Bei Raumtemperatur und Umgebungsluft wird ein 32 Liter PE-Kessel mit 27 Liter destilliertem Wasser gefüllt. Ein Überkopf-Rührer mit einem inversen Teflon-Propeller-Rührer taucht von oben in das Wasser ein, bis eine gute Durchmischung gegeben ist. Nun wird Natrium-Dodecylsulfat (261 g, 8,95 mol) zugefügt und gerührt, bis das SDS gelöst ist.

*Polymerisationsreaktion*

Lösung A wird nun unter Rühren von Lösung B zu Lösung B zugegeben. Dabei bildet sich ein beigerflockiger Niederschlag. Nach 20 Minuten wird zur Suspension 3,4-Ethylendioxythiophen (171 g, 128 ml, 12,0 mol) gegeben. Die Reaktionsmischung wird bei Raumtemperatur für 70 Stunden gerührt, bis sich eine tiefblaue Reaktionsmischung gebildet hat.

*Waschprozess*

Das Rühren wird eingestellt und nach einer Stunde kann der Überstand vorsichtig abdekantiert werden. Der blaue Rückstand wird zentrifugiert und der entstehende Überstand abdekantiert. Dies ergibt 1,0 kg bis 1,1 kg Rohmaterial. Der Rückstand wird in 200 g Portionen aufgeteilt und jeweils folgendermaßen aufgereinigt.

Es folgt die Zugabe von Ethylenglykol:Ethanol (4:1, 800 ml). Anschließend wird die Behandlung mit Ultraschall mittels Sonotrode (15 Minuten kontinuierlich) durchgeführt. Danach wird zentrifugiert und der Überstand abdekantiert.

Diese Schrittabfolge wird nun zweimal wiederholt, wobei reines Ethylenglykol (800 ml) statt dem Ethylenglykol:Ethanol-Gemisch verwendet wird.

Der entstehende blaue Rückstand wird in Ethylenglykol (Verhältnis 200 g PEDOT-Fluid zu 2 l Ethylenglykol) bei 120 °C erhitzt. Anschließend wird heiß zentrifugiert und dekantiert. Der Rückstand stellt eine siebdruckfähige Siebdrucktinte dar.

Die thermoelektrischen Kennzahlen von getrockneten Beschichtungen dieses Fluids betragen 793 S/cm und 21,2 μV/K. Die Messung dieser Kennzahlen ist in Beispiel 1 beschrieben.

**Beispiel 3 - Synthese bei 70 °C**

*Lösung A*

Bei Raumtemperatur wird ein 50 ml Becherglas mit $FeCl_3$ x 6 $H_2O$ (1,67 g, 6,18 mmol) beladen und mit 20 ml destilliertem Wasser gefüllt. Die Mischung wird auf einer Magnetrührplatte bei 500 U/min gerührt bis sich eine orangene trübe Lösung gebildet hat.

*Lösung B*

Bei Raumtemperatur und Umgebungsluft wird ein 2 Liter Kolben mit 1,8 l destilliertem Wasser gefüllt. Unter Rühren wird Natrium-Dodecylsulfat (1,74 g, 5,97 mmol) zugefügt und gerührt bis es gelöst ist und anschließend auf 70 °C erhitzt.

*Polymerisationsreaktion*

Lösung A wird nun unter Rühren von Lösung B zu Lösung B zugegeben. Dabei bildet sich ein flockiger beiger Niederschlag. Nach 20 Minuten wird zur Suspension 3,4-Ethylendioxythiophen (1,14 g, 849 µl, 8 mmol) gegeben. Die Reaktionsmischung wird bei 70 °C für 1,5 Stunden gerührt, bis sich eine tiefblaue Reaktionsmischung gebildet hat.

*Waschprozess*

Das Rühren wird eingestellt und nach einer Stunde kann der Überstand vorsichtig abdekantiert werden. Der blaue Rückstand wird zentrifugiert und der entstehende Überstand abdekantiert. Dies ergibt 20 g bis 30 g PEDOT-Fluid. Der Rückstand wird folgendermaßen aufgereinigt.
Es folgt die Zugabe von Ethylenglykol:Ethanol (4:1, 50 ml). Anschließend wird die Behandlung mit Ultraschall mittels Sonotrode (15 Minuten kontinuierlich) durchgeführt. Danach wird zentrifugiert und der Überstand abdekantiert.
Diese Schrittabfolge wird nun dreimal wiederholt, wobei reines Ethylenglykol (50 ml) statt dem Ethylenglykol:Ethanol-Gemisch verwendet wird.
Nach dem Waschprozess wurden 15,6 g PEDOT-Fluid gewonnen. Die thermoelektrischen Kennzahlen von den getrockneten Beschichtungen dieses Fluids betragen 231 S/cm und 16,6 µV/K. Diese Messwerte wurden wie in Beispiel 1 beschrieben ermittelt.

**Beispiel 4 - Einfluss von Lösungsmittelgemischen auf PEDOT-Drucktinten**

Gezeigt ist ein positiver Einfluss von Ethylenglykol auf die PEDOT-Fluide anhand eines Beispiels mit verschiedenen Verhältnissen aus Ethylenglykol und Wasser. Dazu wurden jeweils 5 g des aus Beispiel 2 synthetisierte PEDOT-Fluids mit jeweils 20 ml an Lösungsmittelgemisch vermengt und zentrifugiert und dekantiert. Dieser Prozess wurde zweimal wiederholt. Je höher der Anteil an Wasser, desto inhomogener das PEDOT-Fluid. Aus inhomogenen PEDOT-Fluiden resultieren inhomogene, schlecht strukturierte Druckbilder. Unter inhomogen wird die qualitative Beobachtung von Agglomeraten in den PEDOT-Fluiden bezeichnet die zu faserigen Kanten von Schichten dieser Fluide nach einem Siebdruckprozess oder Rakelprozess führen.

Tabelle 1: Einfluss des Verhältnisses von Wasser und Ethylenglykol als Lösungsmittel auf PEDOT-Fluide anhand thermoelektrischer Eigenschaften und Homogenität.

| Verhältnis Ethylenglykol : Wasser | Elektrische Leitfähigkeit [S/cm] | Seebeck-Koeffizient [µV/K] | Beobachtung |
|---|---|---|---|
| 0:1 | 685 | 25,9 | Sehr stark inhomogen |
| 1:10 | 685 | 26,1 | Inhomogen |
| 1:5 | 611 | 26,4 | Inhomogen |
| 1:2 | 636 | 25,3 | Leicht Inhomogen |
| 1:1 | 587 | 26,0 | Leicht Inhomogen |
| 2:1 | 567 | 26,6 | Leicht inhomogen |
| 5:1 | 442 | 24,0 | Homogen |

(fortgesetzt)

| Verhältnis Ethylenglykol : Wasser | Elektrische Leitfähigkeit [S/cm] | Seebeck-Koeffizient [μV/K] | Beobachtung |
|---|---|---|---|
| 10:1 | 497 | 24,8 | Homogen |
| 1:0 | 589 | 23,6 | Sehr homogen |

**Beispiel 5 - Unterschiedliche Ethylenglykolmengen beim Kochschritt von PEDOT**

Im letzten Aufreinigungsschritt wird das PEDOT-Fluid in Ethylenglykol bei 120 °C für 1 Stunde erhitzt. Das Verhältnis von Ethylenglykol zu PEDOT-Fluid ist hier stets 10:1. Um diese Menge in Zukunft zu verringern, wurden Experimente durchgeführt um die Menge an benötigtem Ethylenglykol zu verifizieren. In folgender Tabelle sind die Ergebnisse der Untersuchungen dargestellt. Hierbei wurde jeweils 1 g PEDOT-Fluid verwendet und die Menge an Ethylenglykol variiert. Die heißen Mischungen wurden jeweils direkt heiß zentrifugiert und anschließend als gerakelte und getrocknete Filme charakterisiert.

**Tabelle 2:** Auswirkungen der Verwendung von Ethylenglykol in unterschiedlichen Verhältnissen auf verschiedene PEDOT Parameter

| PEDOT : Ethylenglykol | Elektrische Leitfähigkeit [S/cm] | Seebeck-Koeffizient [μV/K\| |
|---|---|---|
| 1:20 | 863 | 21,8 |
| 1:10 | 785 | 22,2 |
| 1:8 | 892 | 21,9 |
| 1:7 | 862 | 22,2 |
| 1:5 | 787 | 22,7 |
| 1:2 | 792 | 20,7 |
| 1:1 | 1019 | 20,8 |

Die obige Tabelle 2 zeigt, dass das Kochen des PEDOT-Fluids in Ethylenglykol auch bei niedrigeren PEDOT : Ethylenglykol Verhältnissen eine hohe spezifische elektrische Leitfähigkeit der PEDOT-Beschichtungen erzeugt.

**Beispiel 6** - **Verwendung der PEDOT-Siebdrucktinte in einem thermoelektrischen Generator**

Das PEDOT-Fluid wurde erfolgreich als p-Typ Material in einem gedruckten thermoelektrischen Generator verwendet.

Die Erfindung wurde anfangs im Labormaßstab im 250 - 500 ml Maßstab erprobt und konnte ohne weiteres in den 30 Liter Maßstab überführt werden. Die 130 g thermoelektrisch aktive Siebdrucktinte auf Basis von PEDOT-Nanostrukturen aus der Vorschrift von Beispiel 2, fand in einem handgedruckten thermoelektrischen Generator Anwendung.

Die PEDOT-Tinte wird 10 Minuten lang mit einem Zahnscheibenrührer durchmischt, bis ein homogenes Gemisch entsteht. Die Drehzahl beträgt hierbei 2500 U/min. Mit Hilfe eines halbautomatischen Siebdruckgerätes und eines Flachsiebes mit einer Maschenperiodizität von 24 Maschen pro cm und einem Fadendurchmesser von 145 μm werden die Thermoschenkel auf ein flaches Substrat aus Polyester gedruckt, in dem die PEDOT-Tinte mit Hilfe einer Gummi-Rakel durch das Siebgewebe gedrückt wird. Die aufgedruckte Nassfilmdicke beträgt hierbei ca. 105 μm. Die bedruckte Fläche beträgt hierbei etwa 15 cm x 15 cm. Unmittelbar nach dem Druck wird die Folie auf eine heiße Platte transferiert. Die PEDOT-Tinte trocknet innerhalb von ca. 5 Minuten und ergibt eine elektrisch leitfähige Schicht.

Die Folie kann entsprechend der internationalen Veröffentlichungsschrift WO 2013/185903 A1 mittels Wickeln und Falten zu einem thermoelektrischen Generator verarbeitet werden. Das Substrat, bei dem es sich um eine isolierende Schicht handelt, wird einmal mit einem p-leitenden und einmal mit einem n-leitenden Material bedruckt, so dass durchgehende mäanderförmige Beschichtung entsteht, in der sich p- und n-leitendes Material in sogenannten Thermopaaren abwechseln. Diese Mäanderstruktur erstreckt sich über mehrere Zeilen. Der Wechsel zwischen p- und n-leitendem Material findet spaltenweise statt. Nach dem Bedrucken des Substrats wird das Substrat entlang der Zeilen aufgewickelt, so dass ein flacher Streifen entsteht, in dem alle Zeilen übereinander liegen. Danach werden Markierungen an den Spalten, d. h. an den Übergängen zwischen den jeweils p- und n-leitenden Materialien, eingeprägt. Dann wird der

Streifen ziehharmonika-förmig zu einem Stapel zusammengefaltet, so dass die eingeprägten Markierungen jeweils die Wellenköpfe und Wellentäler bilden. Anschließend wird der gefaltete Stapel zu einem Block verpresst. Die Kontaktflächen befinden sich dabei außen an den äußersten Stapelschichten, so dass hier später der elektrische Strom abgegriffen werden kann.

Beide Materialien werden mit einem kleinen Überlapp nebeneinander gedruckt, um so eine durchgehende elektrische Kontaktierung zu gewährleisten. Als finale Kontaktierung wird PEDOT mit Silber kontaktiert.

Der PEDOT-Nanostrukturen als p-Material enthaltende thermoelektrische Generator (Figur 2) generierte in Kombination mit einem Titandisulfid-basierten n-Material eine Ausgangsleistung von 24,0 μW bei einer Temperaturdifferenz von 30 K (20 °C Kaltseite, 50 °C Warmseite). Für die Bestimmung der Ausgangsleistung wurde der elektrische Widerstand des thermoelektrischen Generators und die Leerlaufspannung bei der angelegten Temperaturdifferenz gemessen. Die Leistung wurde dann bestimmt, indem das Quadrat der Leerlaufspannung durch den vierfachen Innenwiderstand geteilt wurde.

Die thermoelektrischen Kennzahlen für das so synthetisierte PEDOT-Fluid lauten 829 S/cm für die elektrische Leitfähigkeit und 22,59 μV/K für den Seebeck-Koeffizienten. Die Bestimmung dieser Werte erfolgte mit den in Beispiel 1 beschriebenen Methoden.

Das verwendete n-Material Titandisulfid, besitzt in einer Ausführungsform besipielsweise die thermoelektrischen Kennzahlen 568 S/cm und -85,9 μV/K.

**Beispiel 7** - **Siebdruckfähiges Titandisulfid** für die **Anwendung** in **einem thermoelektrischen Generator als n-Typ Material, auch in Kombination mit dem hier beschriebenen p-Typ Material und Verfahren**

Dieser Aspekt der Erfindung betrifft eine Siebdrucktinte und ein Verfahren zur Herstellung derselben, wobei die Siebdrucktinte thermoelektrische Eigenschaften aufweist. Sie ist geeignet für den rotativen und den sheet-to-sheet Siebdruck auf Polymer- und Glassubstraten.

*Beschreibung*

*Einleitung*

Thermoelektrische Materialien haben die Eigenschaft, aus Temperaturunterschieden Strom zu erzeugen. Sie können auf vielfältige Weise zur Anwendung kommen, z. B. für den Einsatz als unabhängige Energiequelle für drahtlosen Sensoren und Aktoren.

Zur Herstellung eines thermoelektrischen Generators werden Blöcke von thermoelektrisch aktiven Materialien (n-Typ und p-Typ-Materialien) zwischen zwei festen Trägern platziert, miteinander in Kontakt gebracht und einer Temperaturdifferenz ausgesetzt. Dabei liefert der thermoelektrische Generator Strom.

Als p-Typ wird ein halbleitendes Material verstanden, bei dem die Majoritätsladungsträger, also die Ladungsträgerspezies, die den größten Teil des Stroms leitet, Löcher oder Defektelektronen sind. Bei einem n-Typ Material sind die Majoritätsladungsträger Elektronen.

Um thermoelektrische Generatoren per Siebdruck herzustellen, fehlt es an geeigneten Siebdrucktinten, die schnell und kostengünstig hergestellt werden können. Titandisulfid ($TiS_2$) besitzt thermoelektrische Eigenschaften, kann aber bislang nicht flüssigprozessiert werden. Es besteht ein großes Interesse, Titandisulfid in eine siebdruckfähige Form zu überführen, um es so für industrielle Massenproduktionsprozesse verfügbar zu machen.

Der vorliegende Aspekt der Erfindung stellt eine Siebdrucktinte bereit, die zur Herstellung eines thermoelektrischen Generators verwendet werden kann. Das hier beschriebene neue Verfahren stellt Titandisulfid als n-Typ-Material in Form einer Siebdrucktinte, insbesondere zur Herstellung thermoelektrischer Generatoren, zur Verfügung.

Der Begriff "Siebdruck" bezeichnet ein Druckverfahren, bei dem die Druckfarbe mit einer Rakel durch ein feinmaschiges Gewebe hindurch auf das zu bedruckende Material übertragen wird. Der Begriff umfasst sowohl den sogenannte sheet-to-sheet Siebdruck, als auch den rotativen Siebdruck, wie er in Rolle-zu-Rolle Anlagen verwendet wird.

*Syntheseprozess und Eigenschaften der erhaltenen Siebdrucktinte*

In einem ersten Aspekt betrifft die Erfindung ein Verfahren zur Synthese einer thermoelektrischen Siebdrucktinte, wobei Titandisulfid als Edukt für die Synthesereaktion bereitgestellt wird.

In einer Ausführungsform des Syntheseverfahrens wird zusätzlich zu Titandisulfid ein basisches lösliches Amin und *N*-Methylformamid bereitgestellt. Diese Edukte reagieren miteinander und es entsteht eine Siebdrucktinte mit thermoelektrischen Eigenschaften **(Schema 1**).

Ein Amin ist insbesondere "basisch", wenn es einen pKb-Wert im Bereich von 2,50 bis 4,50 hat.

Ein Amin ist insbesondere "löslich", wenn es sich in organischen Lösungsmitteln, wie z. B. *N*-Methylformamid,

*N,N*-Dimethylacetamid, Toluol, Dichlormethan löst und dabei mindestens eine Löslichkeit von 90 g/L erreicht. Die in der Literatur standardmäßig angegebene Löslichkeit in Wasser kann nicht herangezogen werden, da langkettige aliphatische Amine, wie z. B. Nonylamin darin nicht mehr leicht löslich sind und Wasser kein geeignetes Lösungsmittel für Titandisulfid darstellt.

Die Viskosität der Siebrucktinte liegt insbesondere im Bereich von $10^7$ mPas (bei Scherraten von $10^{-3}$ 1/s) bis $10^1$ mPas (bei Scherraten von $10^3$ 1/s), insbesondere im Bereich von $10^6$ mPas (bei Scherraten von $10^{-3}$ 1/s) bis $10^2$ mPas (bei Scherraten von $10^2$ 1/s entsprechend einem scherverdünnendem Fluid). (Die rheologischen Untersuchungen wurden an einem Rheometer des Herstellers Anton Paar mit der Modellbezeichnung Physica MCR 101 mit einer Kegel-Platte Geometrie durchgeführt.)

Das basische lösliche Amin, insbesondere ein basisches lösliches Alkylamin, kann geradkettig oder verzweigt sein. In einer Ausführungsform ist das basische, lösliche Amin ausgewählt aus der Gruppe bestehend aus Propylamin, Butylamin, Pentylamin, Hexylamin, Heptylamin, Octylamin, Nonylamin, 2-Methylbutylamin, 3-Methylpentylamin, 2-Phenylbutan-1-amin, *iso*-Pentylamin und 2-Ethyl-*N*-butylamin.

Weiterhin sind nach dem Verfahren keine Reinigungsschritte nötig. Das Reaktionsprodukt kann unmittelbar als Siebdrucktinte eingesetzt werden.

In einer Ausführungsform wird das Titandisulfid direkt in *N*-Methylformamid vorgelegt und unter Rühren wird Hexylamin zugegeben. Die Reaktionsführung ist auch in dieser Ausführungsform abgeschlossen, sobald sich ein Fluid mit der genannten Viskosität (insbesondere im Bereich von 107 mPas bei Scherraten von 10-3 1/s und bei 101 mPas bei Scherraten von 103 1/s) gebildet hat.

In besonderen Ausführungsformen werden die Edukte unter Schutzgas und/oder nichttrockenen Bedingungen zusammengegeben und 12 bis 144 Stunden bei Raumtemperatur gerührt.

Die thermoelektrischen Eigenschaften werden an trockenen Beschichtungen des Fluids bestimmt (Dicke 0,5 µm bis 10 µm). Hierbei ist auch das dort erreichte Optimum der Reaktionsführung anhand der Maximalwerte der elektrischen Leitfähigkeit (z. B. 764 S/cm) und des Seebeck Koeffizienten (z. B. -75 µV/K) zu beobachten.

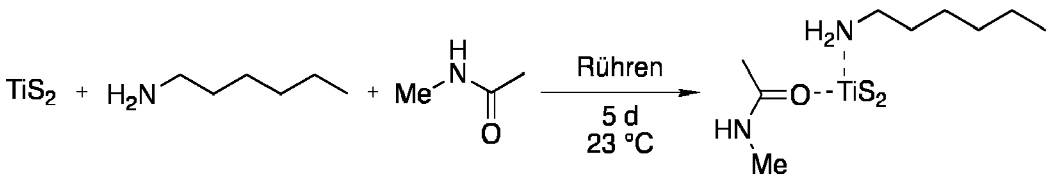


Schema 1.2: Reaktionsgleichung und Prozessführung zur Herstellung eines siebdruckfähigen Fluids, mit einem $TiS_2$-Hexylamin-*N*-Methylformamid-Addukt als möglichem Produkt.

*Synthese in Anwesenheit von Additiven*

In einer Ausführungsform erfolgt die Zugabe eines in *N*-Methylformamid löslichen polymeren Additivs, insbesondere von Polyethylenoxid mit einem Viskositätsmittel ($M_v$) von größer gleich 8.000.000 während der beschriebenen Reaktion (Schema 2.2) oder danach.

Das Additiv sollte nicht durch Sulfide oder das alkalische Milieu der Siebdrucktinte angegriffen werden. In einer Ausführungsform des erfindungsgemäßen Verfahrens ist das polymere Additiv ausgewählt aus der Gruppe bestehend aus Polyglykolen, polymeren Triblock-Copolymeren nach dem Typus Polyethylenglykol-Polypropylenglykol-Polyethylenglykol oder auch Polypropylenglykol-Polyethylenglykol-Polypropylenglykol (Zahlenmittlere Molmasse ($M_n$) = 2000 - 15000), Amide enthaltende Polymere (wie z. B. Polyvinylpyrrolidone, Polyvinylpolypyrrolidon) und Polymeren mit funktionalen Gruppen wie Sulfide (z. B. Polyphenylsulfide) oder Amine (z. B. Polyvinylamin, Polyallylamin oder Polyethylenimin).

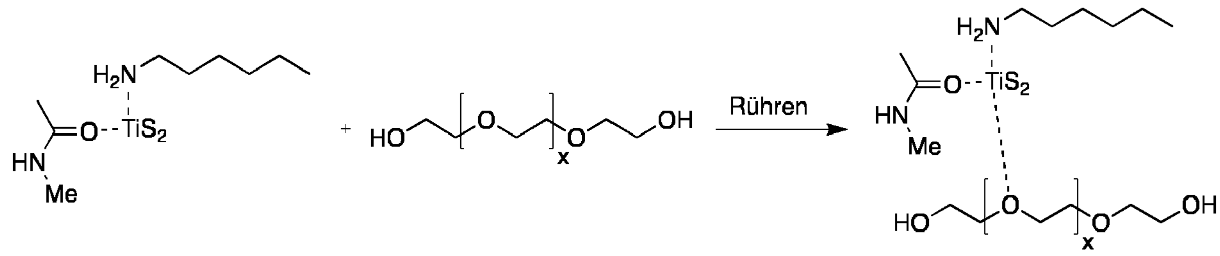


Schema 2.2: Reaktionsgleichung und Prozessführung mit Zugabe eines Additivs; mit einem $TiS_2$-Hexylamin-*N*-Methylformamid-Polyglykol-Addukt als möglichem Produkt.

In einem weiteren Aspekt betrifft die Erfindung die Verwendung von Titandisulfid zur Herstellung einer thermoelektrischen Siebdrucktinte.

In einem weiteren Aspekt betrifft dieser Aspekt der Erfindung eine Siebdrucktinte, aufweisend Titandisulfid, insbesondere herstellbar nach dem hier beschriebenen Verfahren. Dementsprechend können *N*-Methylformamid und ein basisches lösliches Amin sowie optional ein polymeres Additiv als Edukte eingesetzt werden.

In einem weiteren Aspekt betrifft dieser Aspekt der Erfindung die Verwendung eines polymeren Additivs der oben beschriebenen Art, insbesondere von Polyethylenoxid, mit einem Molekulargewicht $M_v$ im Bereich von 100.000-10.000.000, insbesondere mit $M_v >= 8.000.000$ zur Herstellung einer Tinte für den rotativen Siebdruck.

In einem weiteren Aspekt betrifft die Erfindung einen thermoelektrischen Generator mit mindestens einer Schicht, die Titandisulfid aufweist.

In einem weiteren Aspekt betrifft die Erfindung ein Siebdruckverfahren, aufweisend den Schritt der Verwendung einer Siebdrucktinte der in diesem Beispiel beschriebenen Art.

Das erfindungsgemäße Verfahren mittels einfachem Vermischen der Edukte Titandisulfid, Amin (z. B. Hexylamin) und *N*-Methylformamid benötigt keine aufwändige Ultraschallbehandlung. Hierbei entsteht während der Prozessführung die gewünschte sehr viskose Mischung. Die Mischung wird gut gerührt, um eine gute Vermengung des viskosen Gemisches zu gewährleisten.

Dadurch, dass keine Aufreinigung der entstehenden Siebdrucktinte notwendig ist, entfallen kostenintensive Schritte. Dabei wird zum einen Zeit gespart und zum anderen auch Abfall vermieden.

In einer optionalen Ausführungsform werden alle Reaktanden (Titandisulfid, Korngröße mesh 100 (entsprechend einer durchschnittlichen Titandisulfidkorngröße von 150 $\mu$m)) und Reagenzien zusammen unter Schutzgas in einem Reaktionsgefäß gegeben und 1 bis 10 Tage, insbesondere 1 bis 2 Tage, bevorzugt 2 Tage (48 Stunden) gerührt (Schema 3.2). Die Reaktionszeit hängt von den Paramatern: Korn- bzw. Partikelgrößenverteilung des Titandisulfids, Rührgeschwindigkeit und Rührgeometrie ab und kann leicht ermittelt werden.

Hierbei entsteht im Laufe des Syntheseprozesses eine hochviskose pastöse Flüssigkeit (insbesondere mit einer Viskosität von 20 Pas bis 40 Pas bei einer Scherrate von 1 1/s, welche auch den Endpunkt der Reaktion bestimmt. Das heißt, sobald sich deren Konsistenz und Viskosität für den Siebdruck eignet, ist die Reaktion abgeschlossen. Die Synthese wir in bestimmten Ausführungsformen mit wasser- und sauerstofffreien Lösungsmitteln und Reaktanden durchgeführt.

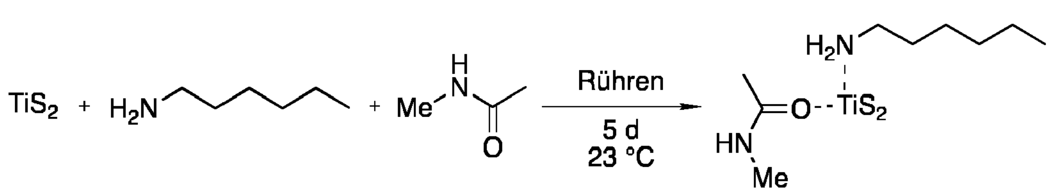


Schema 3.2: Reaktionsabfolge von Titandisulfid zur Herstellung einer Siebdrucktinte, mit einem $TiS_2$-Hexylamin-*N*-Methylformamid-Addukt als möglichem Produkt.

In einer Ausführungsform wird während oder nach der Synthese ein polymeres Additiv, etwa Polyethylenoxid ($M_v >= 8.000.000$) zugegeben (Schema 4.2). Die Zugabe des Additivs führt nicht zu einer Verminderung der thermoelektrischen Eigenschaften.

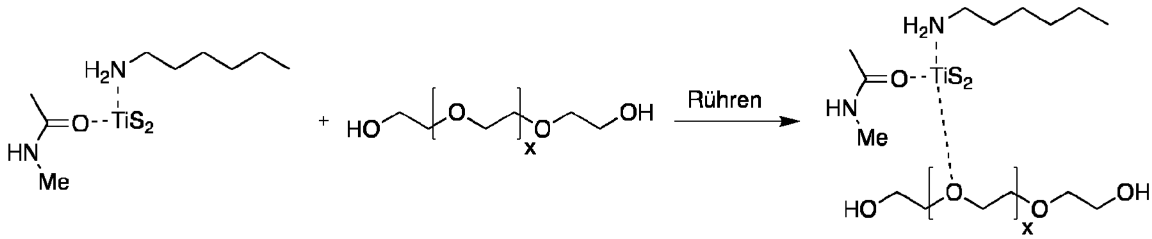


Schema 4.2: Reaktionsabfolge eines $TiS_2$-Hexylamin-*N*-Methylformamid-Addukts mit einem polymeren Additiv, zu einem $TiS_2$-Hexylamin-*N*-Methylformamid-Polymer-Addukt als Produkt.

Beispiel 1.2 - Herstellung von siebdruckfähigem Titandisulfid, hohe Hexylamin Menge

Unter kontinuierlichem Stickstoffstrom wird Titandisulfid (400 mg, 2,57 mmol) in ein wiederverschließbares mit Magnetstäbchen bestücktes Schraubdeckelglas überführt. Nun wird mittels Pipette *N*-Methylformamid (2,5 ml, 42,7 mmol) zugegeben. Anschließend wird direkt Hexylamin zugetropft (166 μl, 1,25 mmol). Hierbei hat das *N*-Methylformamid einen Wassergehalt von ca. 0,02 % und das Hexylamin einen Wassergehalt von ca. 0,06 %. Der Wassergehalt wurde mittels Karl-Fischer Titration (Gerät: analytikjena AQUA 40.00) bestimmt. Nach dem Zutropfen ist schon eine leichte "Bewegung" (bronzefarbene "Blättchen" bilden sich an der Oberfläche) im Glas zu beobachten. Das Schraubdeckelglas wird unter Stickstoffstrom verschlossen und mit Parafilm zusätzlich abgedichtet. Die Mischung wird nun bei 300 U/min für mindestens 1 Tag bei Raumtemperatur gerührt. Nach einer Reaktionszeit von 47 Stunden wurden die thermoelektrischen Parameter der Beschichtungen dieser Drucktinte mit 764 S/cm und -76 μV/K bestimmt. Die Reaktion ist abgeschlossen, sobald sich eine viskose Mischung gebildet hat, die sich für den Siebdruck eignet und direkt charakterisiert werden kann. Dann hat die viskose Mischung insbesondere eine Viskosität von 20 Pas bis 40 Pas bei einer Scherrate von 1 1/s.

Für die Ermittlung der elektrischen Leitfähigkeit wurden Beschichtungen aus den Titandisulfid auf Glasobjektträger aufgebracht. Anschließend wurden mit Hilfe von Silberleitlack zwei Silber-Elektroden auf die Beschichtung aufgetragen. Mit Hilfe eines Multimeters wurde der Widerstand der Schichten gemessen und der Flächenwiderstand (Ω/□) berechnet. Die Schichtdicke der Beschichtungen wurde über ein Dektak XT (Bruker) Profilometer an zwei beliebigen Stellen zwischen den Elektroden gemessen und der Durchschnittswert berechnet. Die spezifische elektrische Leitfähigkeit wurde entsprechend der Formel

$$1 / (\text{Flächenwiderstand} \cdot \text{Schichtdicke})$$

aus den erhaltenen Werten bestimmt.

Der Seebeck-Koeffizient wurde mithilfe von zwei unterschiedlich temperierbaren Peltierelementen gemessen. Die Thermospannung und die anliegende Temperaturdifferenz wurde durch Kupferelektroden direkt auf der Oberfläche des Films auf dem Glasobjektträger gemessen. Aus Messpunkten bei verschiedenen Temperaturdifferenzen wurde der Seebeck-Koeffizient berechnet.

Beispiel 2.2 - Herstellung von siebdruckfähigem Titandisulfid, geringe Hexylamin Menge

Unter kontinuierlichem Stickstoffstrom wird Titandisulfid (400 mg, 2,57 mmol) in ein wiederverschließbares mit Magnetstäbchen bestücktes Schraubdeckelglas überführt. Nun wird mittels Pipette *N*-Methylformamid (2,5 ml, 42,7 mmol) zugegeben. Anschließend wird direkt Hexylamin zugetropft (94,6 μl, 714 μmol). Hierbei ist schon eine leichte "Bewegung" (Bronzefarbene "Blättchen" bilden sich an der Oberfläche) im Glas zu beobachten. Das Schraubdeckelglas wird unter Stickstoffstrom vorsichtig verschlossen und mit Parafilm zusätzlich abgedichtet. Die Mischung wird nun bei 300 U/min für mindestens 1 Tag bei Raumtemperatur gerührt. Nach einer Reaktionszeit von 47 Stunden wurden die thermoelektrischen Parameter der Beschichtungen dieser Drucktinte mit 697 S/cm und -78 μV/K bestimmt. Die Reaktion gilt als abgeschlossen, sobald sich eine viskose Mischung gebildet hat, die direkt charakterisiert werden kann.

Die elektrische Leitfähigkeit und der Seebeck-Koeffizient wurden nach den Methoden aus Beispiel 1 bestimmt.

Beispiel 3.2 - Herstellung von siebdruckfähigem Titandisulfid direkt mit Additiven

Unter kontinuierlichem Stickstoffstrom wird Titandisulfid (400 mg, 2,57 mmol) in ein wiederverschließbares mit

Magnetstäbchen bestücktes Schraubdeckelglas überführt und zusätzlich noch ein polymeres Additiv mit der gelisteten Einwaage hinzugefügt (Tabelle 1). Nun wird mittels Pipette *N*-Methylformamid (2,5 ml, 42,7 mmol) zugegeben. Anschließend wird direkt Hexylamin zugetropft (166 µl, 1,25 mmol). Hierbei ist schon eine leichte "Bewegung" (bronzefarbene "Blättchen" bilden sich an der Oberfläche) im Glas zu beobachten. Das Schraubdeckelglas wird unter Stickstoffstrom vorsichtig verschlossen und mit Parafilm zusätzlich abgedichtet. Die Mischung wird nun bei 300 U/min für mindestens 1 Tag bei Raumtemperatur gerührt. Nach einer Reaktionszeit von 48 Stunden wurden die thermoelektrischen Parameter der Beschichtungen dieser Drucktinte bestimmt (Tabelle 1). Die Reaktion gilt als abgeschlossen, sobald sich eine viskose Mischung gebildet hat, die direkt charakterisiert werden kann. Die hier untersuchten Proben wurden nach 48 Stunden Reaktionsdauer entnommen.

Tabelle 1.2: Synthese direkt mit polymeren Additiven

| Polymeres Additiv | Einwaage Additiv | elektrische Leitfähigkeit [S/cm] | Seebeck-Koeffizient [µV/K] |
|---|---|---|---|
| Polyethylenoxid $M_v$ = 8.000.000 | 1 mg | 423 | -103,8 |
| Polyethylenoxid $M_v$ = 8.000.000 | 5 mg | 509 | -102,7 |
| Polyethylenoxid $M_v$ = 8.000.000 | 10 mg | 557 | -101,5 |

Die elektrische Leitfähigkeit und der Seebeck-Koeffizient wurden nach den Methoden aus Beispiel 1.2 bestimmt.
Die Tabelle 1.2 zeigt, dass der Einfluss von geringen Mengen des polymeren Additivs geringe Auswirkungen auf die thermoelektrischen Kennzahlen des Titandisulfids hat.

Beispiel 4.2 - Herstellung von siebdruckfähigem Titandisulfid, ohne Stickstoffstrom

Titandisulfid (1 g, 9 mmol) wird an Luft in ein wiederverschließbares mit Magnetstäbchen bestücktes Schraubdeckelglas überführt. Nun wird mittels Pipette *N*-Methylformamid (6,36 ml, 107 mmol) zugegeben. Anschließend wird direkt Hexylamin zugetropft (238 µl, 1,8 mmol). Hierbei ist schon eine leichte "Bewegung" (Bronzefarbene "Blättchen" bilden sich an der Oberfläche) im Glas zu beobachten. Die Mischung wird nun bei 300 U/min für mindestens 1 Tag bei Raumtemperatur gerührt. Nach einer Reaktionszeit von 47 Stunden wurden die thermoelektrischen Parameter der Beschichtungen dieser Drucktinte mit 630 S/cm und -120 µV/K bestimmt. Die Reaktion gilt als abgeschlossen, sobald sich eine viskose Mischung gebildet hat, die direkt charakterisiert werden kann.

Beispiel 5.2 - Herstellung von siebdruckfähigem Titandisulfid mit basichen löslichen Aminen

Die Titandisulfid-Tinten wurden nach der Methode von Beispiel 1 hergestellt. Dabei wurde nur das Amin mit den Homologen des Hexylamins ausgetauscht, die molaren Verhältnisse jedoch beibehalten. Die homologen Amine zum Hexylamin ergeben nahezu gleiche thermoelektrische Eigenschaften (Tabelle 2.2). Jedoch ist die Wahl von Hexylamin aufgrund des günstigen Preises deutlich wirtschaftlicher.

Tabelle 2.2: Synthese von Titandisulfid Drucktinte mit homologen Aminen

| Homolges Amin | Elektrische Leitfähigkeit [S/cm] | Seebeck-Koeffizient [µV/K] | Reaktionsdauer [h] |
|---|---|---|---|
| Pentylamin | 512 | -92,9 | 376 |
| Hexylamin | 622 | -91,4 | 376 |
| Heptylamin | 524 | -87,9 | 376 |
| Octylamin | 511 | -94,8 | 376 |
| Nonylamin | 515 | -118,7 | 377 |

Die elektrische Leitfähigkeit und der Seebeck-Koeffizient wurden nach den Methoden aus Beispiel 1.2 bestimmt.
Tabelle 2.2 zeigt, dass der Einfluss verschiedener basischen löslichen, insbesondere aliphatischen Aminen auf die angegebenen thermoelektrischen Kennzahlen.

Beispiel 6.2 - Polymere Additive zu synthetisiertem Titandisulfid Fluid

Die Titandisulfid-Tinte aus Beispiel 1 wurde verwendet. Jeweils 10 mg des polymeren Additivs wurden in 1 ml *N*-Methylformamid gelöst und 10 µl zu 1 g Titandisulfid-Tinte gegeben und anschließend mittels Spatel verrührt. Hier wird deutlich, dass eine Additiv Zugabe in diesem Bereich kaum Auswirkung auf die thermoelektrischen Eigenschaften der Titandisulfid Beschichtungen hat.

Tabelle 3.2: Zugabe polymerer Additive nach durchgeführter Synthese

| Polymeres Additiv | Elektrische Leitfähigkeit [S/cm] | Seebeck-Koeffizient [µV/K] |
|---|---|---|
| Polyethylenoxid $M_v$ 100.000 | 604 | -98,4 |
| Polyethylenoxid $M_v$ 8.000 | 620 | -104 |
| Polyethylenglykol 400 | 628 | -95,2 |
| Polyethylenglykol-Polypropylenglykol-Polyethylenyglykol Triblock Copolymer $M_n$ 14600 | 759 | -103 |
| Polyvinylpyrrolidone $M_w$ 160.000 | 620 | -100,2 |
| Polyvinylpyrrolidone $M_w$ 60.000 | 681 | -97,2 |
| - (additivlose Referenzprobe) | 679 | -101,0 |

Die elektrische Leitfähigkeit und der Seebeck-Koeffizient wurden nach den Methoden aus Beispiel 1.2 bestimmt. Die Bedeutung von $M_n$ und $M_v$ wurde obigen erläutert. Bei $M_w$ handelt es sich um das Gewichtsmittlere von Polymeren.

Tabelle 3.2 zeigt den Einfluss der Zugabe polymerer Additive zur abgeschlossenen Reaktion auf verschiedene thermoelektrischen Kennzahlen. Einzig die Verwendung des Triblock-Copolymers Polyethylenglykol-Polypropylenglykol-Polyethylenyglykol mit einem $M_n$ von 14600 zeigt einen signifikanten Anstieg der spezifischen elektrischen Leitfähigkeit.

Beispiel 7.2 - Anwendung in einem gedruckten thermoelektrischen Generator

Das Titandisulfid-Fluid wurde erfolgreich in einem gedruckten thermoelektrischen Generator verwendet.

Die Titandisulfid-Siebdrucktinte wurde 10 Minuten lang mit einem Zahnscheibenrührer durchmischt, bis ein homogenes Gemisch entstand. Die Drehzahl betrug hierbei 2500 U/min. Mit Hilfe eines halbautomatischen Siebdruckgerätes und eines Flachsiebes mit einer Maschenperiodizität von 24 Maschen pro cm und einem Fadendurchmesser von 145 µm wurden die Thermoschenkel auf ein flaches Substrat aus Polyester gedruckt, in dem die $TiS_2$-Tinte mit Hilfe eines Gummi-Rakels durch das Siebgewebe gedrückt wurde. Die aufgedruckte Nassfilm-Schichtdicke betrug hierbei ca. 105 µm. Die bedruckte Fläche betrug hierbei etwa 15 cm x 15 cm. Unmittelbar nach dem Druck wurde die Folie auf eine heiße Platte transferiert. Die $TiS_2$-Tinte trocknete innerhalb von ca. 5 Minuten und ergab eine elektrisch leitfähige Schicht.

Die Folie wurde entsprechend der internationalen Veröffentlichungsschrift WO 2013/185903 A1 mittels Wickeln und Falten zu einem thermoelektrischen Generator verarbeitet. Das Substrat, bei dem es sich um eine isolierende Schicht handelt, wird derart einmal mit einem p-leitenden und einmal mit einem n-leitenden Material bedruckt, dass eine durchgehende mäanderförmige Beschichtung entsteht, in der sich p- und n-leitendes Material in sogenannten Thermopaaren abwechseln. Diese Mäanderstruktur erstreckt sich über mehrere Zeilen. Der Wechsel zwischen p- und n-leitendem Material findet spaltenweise statt. Nach dem Bedrucken des Substrats wird das Substrat entlang der Zeilen aufgewickelt, so dass ein flacher Streifen entsteht, in dem alle Zeilen übereinander liegen. Danach werden Markierungen an den Spalten, d. h. an den Übergängen zwischen den jeweils p- und n-Typ-Materialien, eingeprägt. Dann wird der Streifen ziehharmonika-förmig zu einem Stapel zusammengefaltet, so dass die eingeprägten Markierungen jeweils die Wellenköpfe und Wellentäler bilden. Anschließend wird der gefaltete Stapel zu einem Block verpresst. Die Kontaktflächen befinden sich dabei außen an den äußersten Stapelschichten, so dass hier später der elektrische Strom abgegriffen werden kann.

Der Titandisulfid enthaltende thermoelektrische Generator generierte in Kombination mit Poly-3,4-ethylendioxythiophen (PEDOT) basierten p-Typ Material eine Ausgangsleistung von 24,0 µW bei einer Temperaturdifferenz von

30 K (20 °C Kaltseite, 50 °C Warmseite) (Figur 2). Für die Bestimmung der Ausgangsleistung wurde der elektrische Widerstand des thermoelektrischen Generators und die Leerlaufspannung bei der angelegten Temperaturdifferenz gemessen. Die Leistung wurde dann berechnet, indem das Quadrat der Leerlaufspannung durch den vierfachen Innenwiderstand geteilt wurde.

Die thermoelektrischen Kennzahlen für die so synthetisierte Titandisulfid-Drucktinte lauten 568 S/cm für die elektrische Leitfähigkeit und -85,90 μV/K für den Seebeck-Koeffizienten. Das verwendete p-Material PEDOT besitzt die thermoelektrischen Kennzahlen 829 S/cm und 22,59 μV/K. Die Materialien wurden überlappend gedruckt. Die Bestimmung dieser Werte erfolgte mit den in Beispiel 1.2 beschriebenen Methoden.

Ein Aspekt der Erfindung betrifft ein Verfahren zur Herstellung eines thermoelektrischen Generators, bei dem beide hier beschriebene Verfahren zur Herstellung einer Siebdrucktinte (p- und n-Typ) kombiniert werden. Es kann somit ein thermoelektrischer Generator bereitgestellt werden, der die entsprechenden Schichten (p- und n-Typ) aufweist. Ein weiterer Aspekt betrifft einen thermoelektrischen Generator, der jeweils mindestens eine Schicht der hierin beschriebenen Siebdrucktinten (p- und n-Typ) aufweist.

## Figuren

Es zeigen:

Figur 1 Reaktion zur Herstellung von PEDOT-Nanostrukturen als Siebdrucktinte. (Strukturelle Eigenschaften sichtbar *via* REM-Aufnahme: Länge ca. 2 μm bis 30 μm und Durchmesser ca. 20 nm bis 200 nm.) Eine schlechte Morphologie ist charakterisiert durch verklebte und agglomerierte Nanostrukturen. Freie einzelne und engmaschig verknüpfte Nanostrukturen führen zu einer guten Morphologie.)

Figur 2 Mit $TiS_2$ als n-Material und mit den erfindungsrelevanten PEDOT-Nanostrukturen als p-Material bedruckte PET-Folie (24 μm) (A), als fertiger gewickelter und gefalteter thermoelektrischer Generator (*B*)

Figur 3 Abhängigkeit der Parameter Temperatur und der Reaktionsdauer der PEDOT-Nanostruktur-Synthese. Durchgeführt wurden die Synthesen mit 30 mmol/l SDS, 30 mmol/l $FeCl_3$ x $(H_2O)_6$ und 40 mmol/l EDOT. Abgebildet sind die jeweiligen elektrischen Leitfähigkeiten der PEDOT-Filme auf den Substraten aus den jeweiligen temperaturabhängigen Synthesen.

Figur 4 Schematische Darstellung des Prozesses zur Herstellung von PEDOT-Drucktinte.

I) Wässrige SDS Lösung
II) Wässrige Eisen(III)-Chlorid Lösung
III) Kombination der SDS- und Eisen(III)-Lösung führt zu einem flockigen beigen Niederschlag.
IV) Rühren des flockigen Niederschlags und Zugabe des EDOTs.
V) Blaufärbung des rührenden Gemisches nach abgeschlossener Reaktion (z. B. 72 h, 23 °C)
VI) Erhalt des blauen PEDOT-Rückstandes nach Zentrifugieren und Dekantieren.

Beispiel des Aufreinigungsprozesses Der aus Schritt VI erhaltene PEDOT-Rückstand, hier als Roh-PEDOT bezeichnet, wird mit Lösungsmittel versetzt und mittels eines Ultraschallfingers homogenisiert. Anschließend wird zentrifugiert und dekantiert. Mit dem gewonnenen Rückstand kann die obige Prozessführung wiederholt werden, beispielsweise zweimal. Das dann erhaltene PEDOT wird z. B. in einem Verhältnis von 10:1 mit Ethylenglykol versetzt und z. B. bei 120 °C z. B. eine Stunde lang erhitzt. Nachfolgend wird vorteilhafter Weise zentrifugiert und dekantiert.

## Patentansprüche

**1.** Verfahren zur Herstellung von Poly(3,4-ethylendioxythiophen) (PEDOT) Siebdrucktinte, umfassend die Schritte

a) Bereitstellung von

- 3,4-Ethylendioxythiophen Monomeren,
- Micellen aus Natrium-Dodecylsufat (SDS) und
- Eisen(III)-Chlorid; und

b) Reaktion der unter a) genannten Edukte zu PEDOT-Nanostrukturen,
**dadurch gekennzeichnet, dass**
die erhaltenen PEDOT-Nanostrukturen mit

- mindestens einem Lösungsmittel, insbesondere mit mindestens einem Glykol, und/oder
- einem Lösungsmittelgemisch aufweisend einen aliphatischen Alkohol, insbesondere Ethanol, gewaschen werden.

**2.** Verfahren nach Anspruch 1, wobei

- das mindestens eine Lösungsmittel ausgewählt ist aus der Gruppe bestehend aus: Ethylenglykol (Ethan-1,2-diol), Diethylenglykol, Ethylenglykolmonomethylether, Ethylenglykol dimethylether, Dimethylacetamid, Triethylenglykol, Tetraethylenglykol, Triethylenglykol monomethylether, Triethylenglykoldimethylether (1,2-Bis(2-methoxyethoxy)ethan), Tetraethylenglykolmonomethylether und Tetraethylenglykoldimethylether; und
- der aliphatische Alkohol ausgewählt ist aus der Gruppe bestehend aus: Methanol, Ethanol, 1-Propanol, 2-Propanol, 1-Butanol, 2-Butanol, 1-Pentanol, 2-Pentanol, 1-Hexanol, 2-Hexanol, 1-Heptanol, 2-Heptanol, 1-Octanol, 2-Octanol, 1-Nonanol, 2-Nonanol, 1-Decanol und 2-Decanol.

**3.** Verfahren nach Anspruch 1 oder 2, wobei das Waschen mit einem Gemisch aus dem Lösungsmittel und dem aliphatischen Alkohol, insbesondere Ethanol im Verhältnis 3:1 bis 5:1 durchgeführt wird.

**4.** Verfahren nach Anspruch 1 bis 3, wobei das Waschen mit einem Ethylenglykol:Ethanol Gemisch im Verhältnis von 4:1 durchgeführt wird.

**5.** Verfahren nach Anspruch 1 bis 4, wobei die gewaschenen PEDOT-Nanostrukturen nachfolgend mit einem großen Überschuss in Ethylenglykol gekocht werden.

**6.** Verfahren nach Anspruch 5, wobei die gewaschenen PEDOT-Nanostrukturen bei einer Temperatur von 100 °C bis 130 °C, insbesondere bei 120 °C gekocht werden.

**7.** Verfahren nach Anspruch 1 bis 6, wobei die gewaschenen PEDOT-Nanostrukturen nach dem Erhitzen in einem Überschuss von Ethylenglykol heiß zentrifugiert werden.

**8.** Verfahren nach Anspruch 1 bis 7, umfassend die Zugabe eines polymeren Additivs welches sich in den für die PEDOT-Nanostrukturen ausgewählten Lösungsmittel, auch unter Hitzeeinwirkung, löst.

**9.** Verfahren nach Anspruch 1 bis 8, wobei das polymere Additiv ein Viskositätsmittel $M_v$ von 100.000 bis 10.000.000 besitzt und in kaltem oder heißem Ethylenglykol löslich ist.

**10.** Verfahren nach Anspruch 1 bis 9, wobei das polymere Additiv Polyethylenoxid oder Polyvinylpyrrolidon mit $M_v$ >= 8.000.000 ist.

**11.** Verwendung von Poly(3,4-ethylendioxythiophen) Siebdrucktinte zur Herstellung eines thermoelektrischen Generators.

**12.** Siebdrucktinte, herstellbar durch ein Verfahren nach Anspruch 1 bis 10.

**13.** Verwendung eines Lösungsmittels, (insbesondere mindestens eines Glykols, und/oder eines Lösungsmittelgemischs aufweisend einen aliphatischen Alkohol zur Herstellung einer Tinte für den Siebdruck, insbesondere für den rotativen Siebdruck.

**14.** Thermoelektrischer Generator, aufweisend eine Schicht einer Siebdrucktinte nach Anspruch 12, insbesondere weiterhin aufweisend eine Schicht aufweisend Titandisulfid.

**15.** Siebdruckverfahren, insbesondere zur Herstellung eines thermoelektrischen Generators, aufweisend den Schritt der Verwendung einer Siebdrucktinte nach Anspruch 12.

**Figur 1**

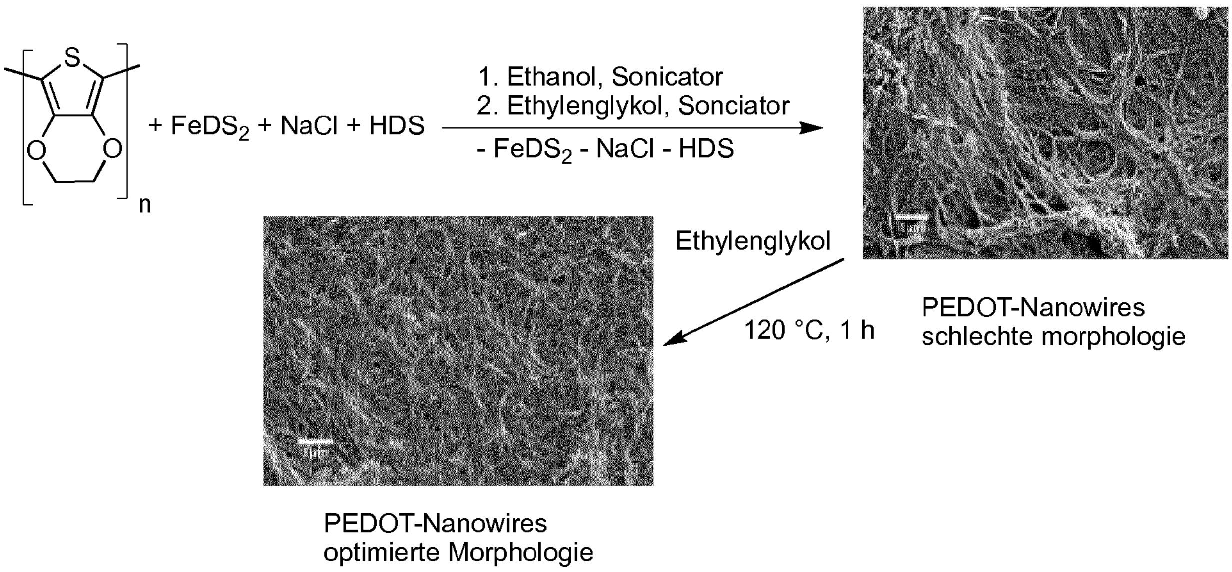
+ $FeDS_2$ + NaCl + HDS
1. Ethanol, Sonicator
2. Ethylenglykol, Sonciator
- $FeDS_2$ - NaCl - HDS
Ethylenglykol
120 °C, 1 h
PEDOT-Nanowires
schlechte morphologie
PEDOT-Nanowires
optimierte Morphologie

Figur 2

A

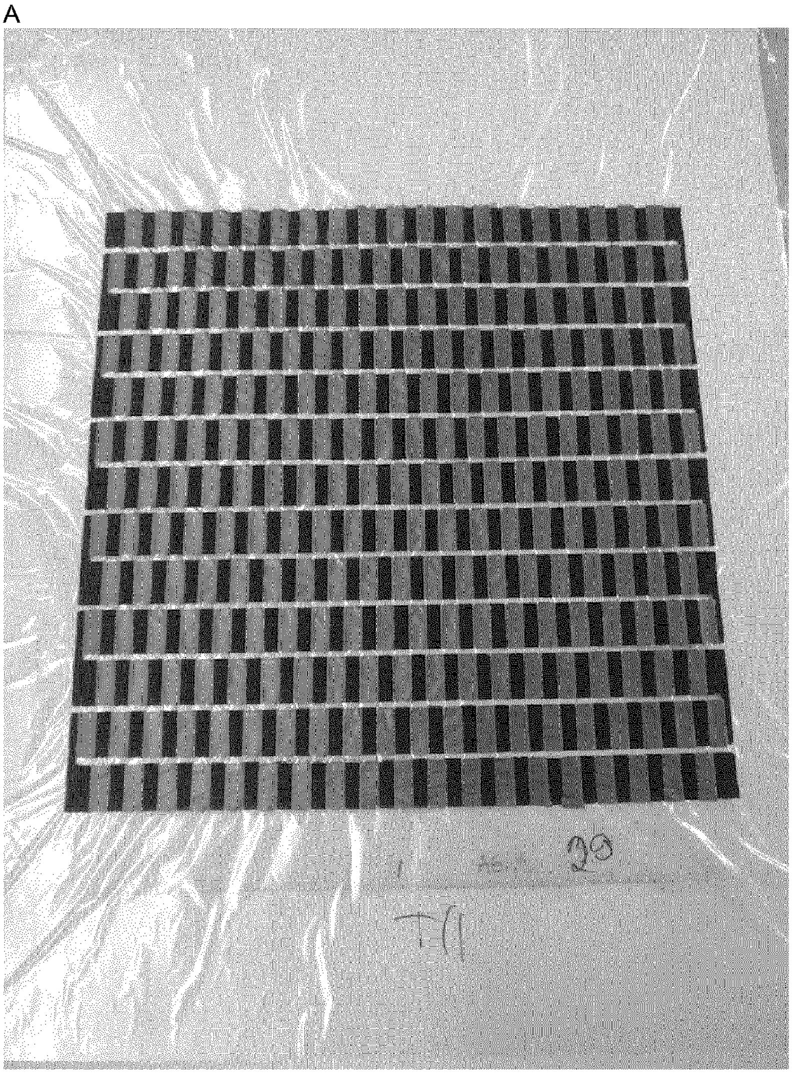

B

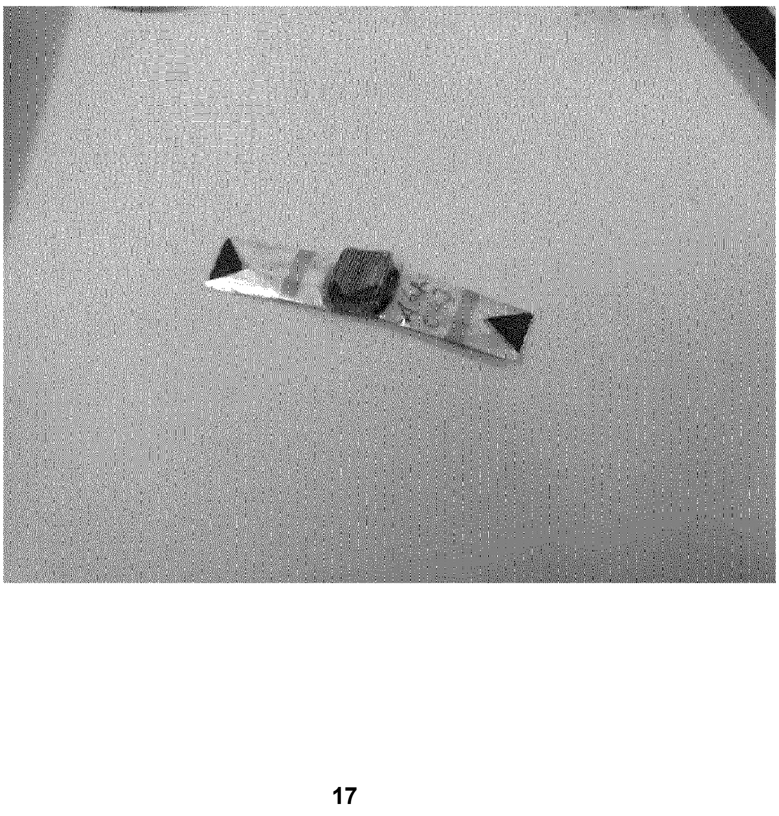

Figur 3

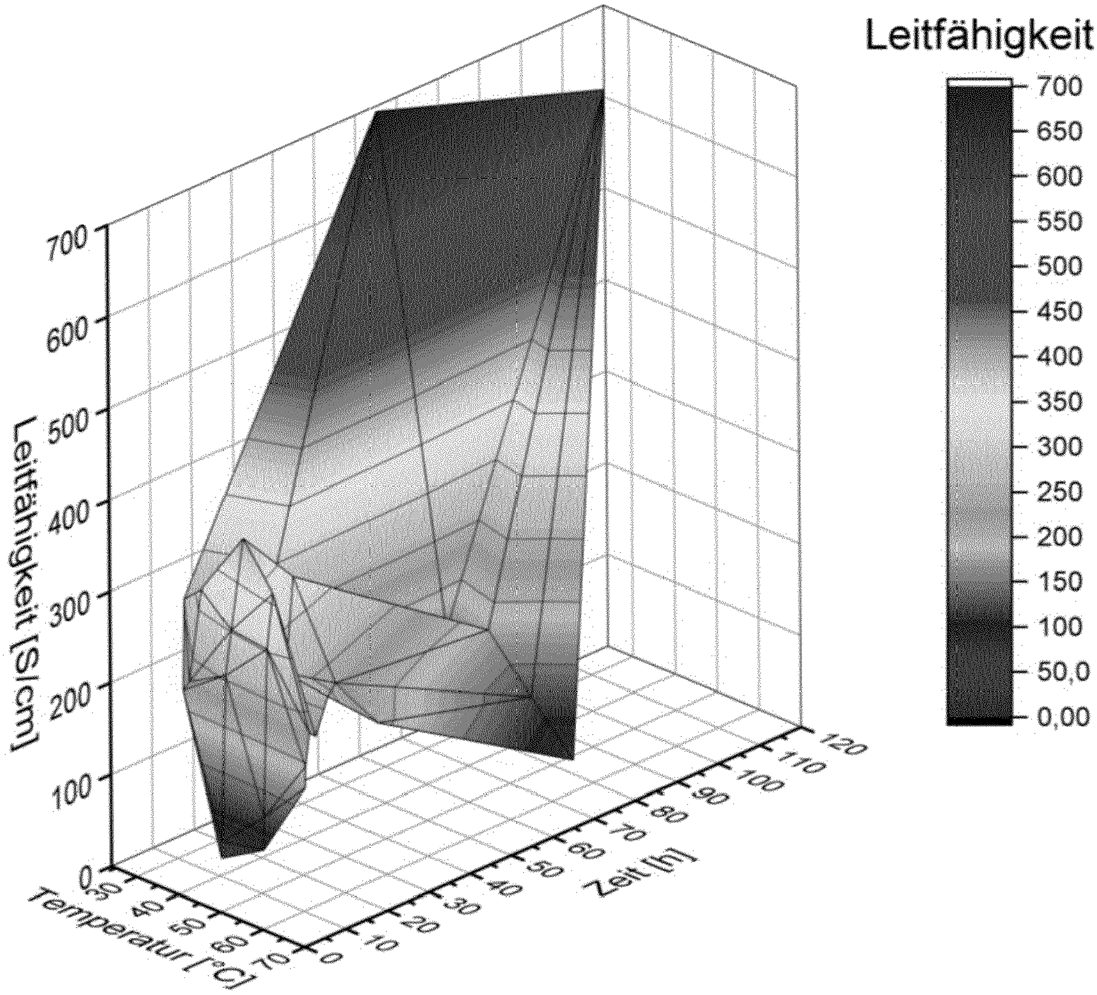
Leitfähigkeit
700
650
600
550
500
450
400
350
300
250
200
150
100
50,0
0,00
Leitfähigkeit [S/cm]
0
100
200
300
400
500
600
700
Temperatur [°C]
30
40
50
60
70
Zeit [h]
0
10
20
30
40
50
60
70
80
90
100
110
120

## Figur 4

### Syntheseprozess im Labormaßstab

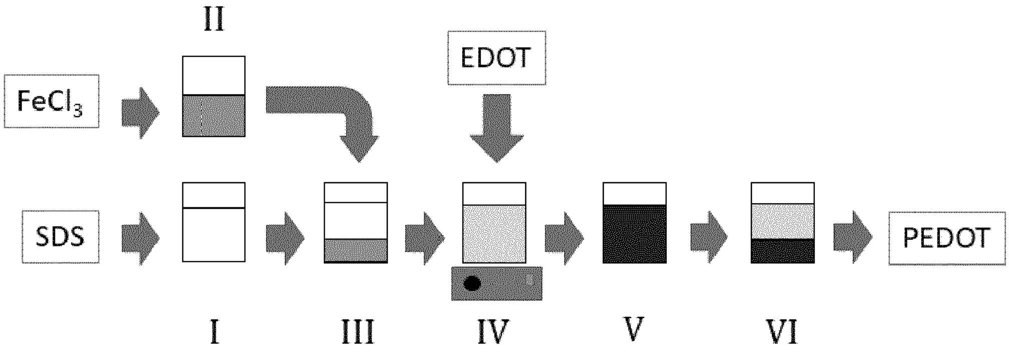


**I**: Wässrige SDS-Lösung
**II**: Wässrige Eisen(III)-Chlorid Lösung
**III**: Bildung des Eisen(III)-SDS-Niederschlags
**IV**: Zugabe EDOT und Start der Reaktion
**V**: Nach abgeschlossener Reaktion (72 h, 23 °C)
**VI**: Zentrifugiert

### Aufreinigungsprozess im Labormaßstab

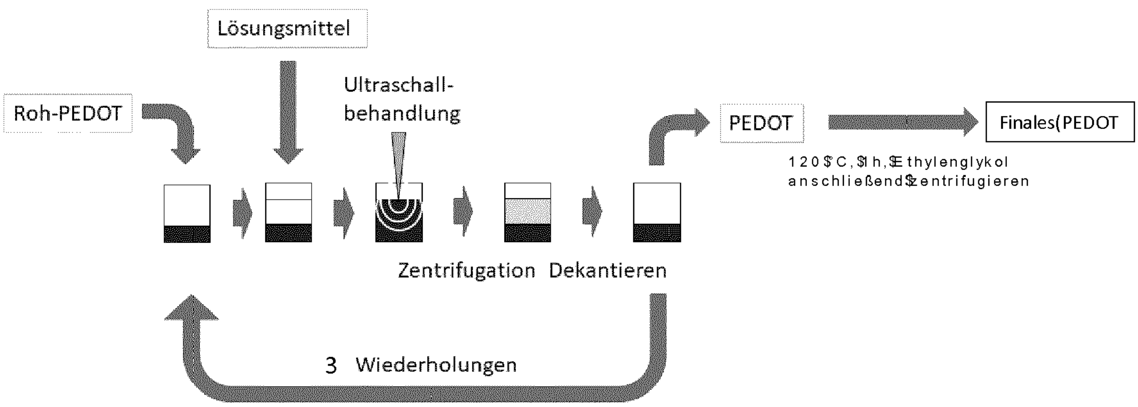

Europäisches Patentamt
European Patent Office
Office européen des brevets

# EUROPÄISCHER RECHERCHENBERICHT

Nummer der Anmeldung
EP 18 19 0210

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JING ZHANG ET AL: "Thermoelectric transport in ultrathin poly(3,4-ethylenedioxythiophene) nanowire assembly", COMPOSITES:PART B, Bd. 136, 4. November 2017 (2017-11-04), Seiten 234-240, XP055568895, AMSTERDAM, NL ISSN: 1359-8368, DOI: 10.1016/j.compositesb.2017.10.037 * Zusammenfassung * * Textabschnitt "2. Experimental" auf Seiten 234-235 * ----- | 1-3,11, 12,14 | INV. C09D165/00 C08L65/00 H01L35/24 H01L35/28 C09D5/24 C09D11/52 |
| X | MOON GYU HAN ET AL: "Facile Synthesis of Poly(3,4-ethylenedioxythiophene) Nanofibers from an Aqueous Surfactant Solution", SMALL, Bd. 2, Nr. 10, 29. August 2006 (2006-08-29), Seiten 1164-1169, XP055568892, DE ISSN: 1613-6810, DOI: 10.1002/smll.200600135 * Zusammenfassung * * Textabschnitt "Experimental Section" auf Seite 1168 * ----- -/-- | 1,2,12 | RECHERCHIERTE SACHGEBIETE (IPC) C09D C08L H01L C08G C09G |

~~Der vorliegende Recherchenbericht wurde für alle Patentans~~prüche erstellt

2

| Recherchenort | Abschlußdatum der Recherche | Prüfer |
|---|---|---|
| München | 19. März 2019 | Meiners, Christian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 18 19 0210

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | CARRASCO-VALENZUELA LORENA ET AL: "Synthesis of graphene oxide/poly(3,4-ethylenedioxythiophene) composites by Fenton's reagent", POLYMER, Bd. 130, 9. November 2017 (2017-11-09), Seiten 124-134, XP085269939, ISSN: 0032-3861, DOI: 10.1016/J.POLYMER.2017.10.013 * das ganze Dokument * ----- | 1,2,12 | |
| A | KUN ZHANG ET AL: "Thermoelectric properties of PEDOT nanowire/PEDOT hybrids", NANOSCALE, Bd. 8, Nr. 15, 29. März 2016 (2016-03-29), Seiten 8033-8041, XP055569072, United Kingdom ISSN: 2040-3364, DOI: 10.1039/C5NR08421K * Zusammenfassung * ----- | 1-12,14, 15 | |
| | | | RECHERCHIERTE SACHGEBIETE (IPC) |
| X | CN 106 750 195 A (UNIV TIANJIN POLYTECHNIC) 31. Mai 2017 (2017-05-31) * Ansprüche 1-5; Beispiele 1-6 * ----- | 1-3,11, 12,14 | |
| X | SUN TIAN ET AL: "Facile synthesis of Poly(3,4-ethylenedioxythiophene) nanostructure with controlled morphologies by using an aqueous surfactant soft-template-assisted technique", MATERIALS LETTERS, ELSEVIER, AMSTERDAM, NL, Bd. 191, 5. Januar 2017 (2017-01-05), Seiten 61-64, XP029902071, ISSN: 0167-577X, DOI: 10.1016/J.MATLET.2016.12.135 * das ganze Dokument * ----- -/-- | 1-3,11, 12,14,15 | |

2

~~Der vorliegende Recherchenbericht wurde für alle Patentans~~prüche erstellt

| Recherchenort | Abschlußdatum der Recherche | Prüfer |
|---|---|---|
| München | 19. März 2019 | Meiners, Christian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 18 19 0210

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CN 107 082 873 A (MATERIALS-X CO LTD) 22. August 2017 (2017-08-22) * Beispiele 1,6 * | 1-3, 8-10,12 | |
| X | KR 101 726 127 B1 (IUCF-HYU [KR]) 12. April 2017 (2017-04-12) * Absatz [0071] - Absatz [0084] * | 1,2,11, 12,15 | |
| A | KUN ZHANG ET AL: "Effect of host-mobility dependent carrier scattering on thermoelectric power factors of polymer composites", NANO ENERGY, Bd. 19, 17. November 2015 (2015-11-17), Seiten 128-137, XP055569320, ISSN: 2211-2855, DOI: 10.1016/j.nanoen.2015.11.005 * Textabschnitt "Results and discussions" auf Seiten 129 - 135; Tabellen 1,2 * | 1-12,14, 15 | |
| | | | RECHERCHIERTE SACHGEBIETE (IPC) |

2

~~Der vorliegende Recherchenbericht wurde für alle Patentans~~prüche erstellt

| Recherchenort | Abschlußdatum der Recherche | Prüfer |
|---|---|---|
| München | 19. März 2019 | Meiners, Christian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................................
& : Mitglied der gleichen Patentfamilie, übereinstimmendes Dokument

EPO FORM 1503 03.82 (P04C03)

Europäisches Patentamt
European Patent Office
Office européen des brevets

Nummer der Anmeldung

EP 18 19 0210

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

1-12, 14, 15

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches Patentamt
European Patent Office
Office européen des brevets

# MANGELNDE EINHEITLICHKEIT DER ERFINDUNG ERGÄNZUNGSBLATT B

Nummer der Anmeldung

EP 18 19 0210

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-12, 14, 15

Verfahren zur Herstellung von Poly(3,4-ethylendioxythiophen) (PEDOT) Siebdrucktinte nach unabhängigem Anspruch 1, Siebdrucktinte herstellbar durch ein Verfahren nach Anspruch 1 gemäß Anspruch 12, Siebdruckverfahren aufweisend den Schritt der Verwendung einer Siebdrucktinte nach Anspruch 12 gemäß Anspruch 15, thermoelektrischer Generator aufweisend eine Schicht einer Siebdrucktinten nach Anspruch 12 gemäß Anspruch 14; Verwendung von PEDOT Siebdrucktinten zur Herstellung eines thermoelektrischen Generators.

---

2. Anspruch: 13

Verwendung eines Lösungsmittels zur Herstellung einer Tinte für den Siebdruck gemäß Anspruch 13.

---

**ANHANG ZUM EUROPÄISCHEN RECHERCHENBERICHT ÜBER DIE EUROPÄISCHE PATENTANMELDUNG NR.** EP 18 19 0210

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-03-2019

| Im Recherchenbericht angeführtes Patentdokument | Datum der Veröffentlichung | Mitglied(er) der Patentfamilie | Datum der Veröffentlichung |
|---|---|---|---|
| CN 106750195 A | 31-05-2017 | KEINE | |
| CN 107082873 A | 22-08-2017 | KEINE | |
| KR 101726127 B1 | 12-04-2017 | KEINE | |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2013185903 A1